Europäisches Patentamt

European Patent Office

Office européen des brevets

(19)

(11) **EP 1 085 624 A1**

(12) **DEMANDE DE BREVET EUROPEEN**

(43) Date de publication:
**21.03.2001 Bulletin 2001/12**

(51) Int Cl.$^7$: **H01S 5/068**

(21) Numéro de dépôt: **00402512.8**

(22) Date de dépôt: **12.09.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **17.09.1999  FR 9911667**

(71) Demandeur: **THOMSON-CSF
75008 Paris (FR)**

(72) Inventeur: **Pez, Mathias,
Thomson-CSF P.I. Dept. Brevet
94117 Arcueil Cedex (FR)**

(54) **Procédé et dispositif de contrôle de la puissance optique d'un émeteur laser**

(57)    L'invention concerne le contrôle de la puissance optique délivrée par un émetteur à diode laser.

Le procédé de contrôle de la puissance optique d'un émetteur laser du type comportant une diode laser et des moyens en courant pour fournir à la diode laser des courants de commande faits d'un courant de polarisation et d'un courant de modulation, comporte au moins les étapes suivantes :

• établir une relation ou approximation mathématique du second ordre ou plus représentative des variations du courant de seuil ou de la variation de puissance de la diode laser en fonction de la température, et

• faire varier le courant de polarisation $I_p$ et/ou la valeur du courant de modulation $I_m$ en fonction de la valeur issue de l'approximation mathématique.

Application à la production de modules électroniques permettant de réaliser des interconnexions optoélectroniques à faible coût.

FIG.3

**Description**

La présente invention concerne le contrôle de la puissance optique d'un émetteur laser du type comportant une diode laser et des moyens en courant pour fournir à la diode laser un courant de commande composé d'un courant de polarisation et d'un courant de modulation.

L'invention s'applique en particulier aux émetteurs lasers de type VCSEL abréviation anglo-saxonne de Vertical Cavity Surface Emitting Laser.

Elle peut aussi être utilisée pour des diodes dont la variation de la puissance optique ou du courant de seuil en fonction de la température peut être représentée par une relation mathématique du second ordre ou plus.

Pour contrebalancer les effets de la température sur la puissance optique délivrée par un émetteur laser, il est connu de réaliser un contrôle de cette puissance d'émission au moyen d'une photodiode de contre-réaction. La photodiode mesure la puissance optique délivrée et, en fonction du résultat de cette mesure, les courants de polarisation et/ou de modulation de la diode laser sont réglés afin que la puissance optique émise reste sensiblement constante.

Cette façon de procéder présente toutefois deux inconvénients :

- la partie de la puissance optique prélevée pour effectuer la mesure diminue le rendement optique global de l'émetteur,
- la nécessité d'un couplage optique de la photodiode à la diode laser au moyen par exemple d'un miroir semi-réfléchissant. Un tel agencement augmente fortement le coût de l'émetteur laser en raison des constituants mis en oeuvre et de l'obligation de les positionner de manière très précise par rapport à la diode laser.

L'objet de l'invention concerne un procédé de contrôle en puissance optique et un dispositif adapté mettant en oeuvre une approximation mathématique du second ordre ou plus de la variation du courant de seuil ou de la puissance de la diode en fonction de la température et à une correction du courant de commande en fonction du résultat de cette approximation.

Le courant de seuil $I_s$ est défini comme étant le courant minimal nécessaire pour obtenir l'émission stimulée de la diode.

L'invention concerne un procédé de contrôle de la puissance optique d'un émetteur laser du type comportant une diode laser et des moyens en courant pour fournir à la diode laser des courants de commande faits d'un courant de polarisation et d'un courant de modulation.

Il est caractérisé en ce qu'il comporte au moins les étapes suivantes :

- établir une relation ou approximation mathématique du second ordre ou plus représentative des variations du courant de seuil ou de la variation de puissance de la diode laser en fonction de la température, et
- faire varier le courant de polarisation $I_p$ et/ou le courant de modulation $I_m$ en fonction de la valeur issue de l'approximation.

La valeur de courant de polarisation $I_p$ et/ou la valeur du courant de modulation $I_m$ sont déterminées par exemple à partir d'une mesure de la température ou d'une mesure de la tension V aux bornes de la diode laser et d'une relation entre la variation de la tension V et la température T.

L'invention concerne aussi un dispositif de contrôle en température d'une diode laser du type comportant une diode laser, un générateur de courant de polarisation ($S_p$) et/ou un générateur de courant de modulation ($S_m$).

Il est caractérisé en ce qu'il comporte au moins :

- un dispositif permettant d'établir et/ou de mémoriser au moins une relation mathématique de second ordre ou plus entre la variation du courant de seuil $I_s$ de la diode laser et la température T et de déterminer une valeur de courant,
- un dispositif capable de déterminer au moins un paramètre représentatif de la variation du courant de seuil $I_s$ ou de la puissance optique P de la diode en fonction de la température T de la diode,
- un dispositif de commande et de contrôle adapté à générer un signal de commande pour faire varier le courant de polarisation $I_p$ et/ou le courant de modulation $I_m$ en fonction du résultat issu du dispositif d'approximation.

Le dispositif capable de déterminer le paramètre représentatif de la variation du courant de seuil $I_s$ ou de la puissance optique P de la diode en fonction de la température T de la diode est un dispositif de mesure de la température ou un dispositif de mesure de la tension aux bornes de la diode et un dispositif adapté à établir et/ou à mémoriser une relation entre la variation de la tension en fonction de la température.

Le dispositif et le procédé selon l'invention s'applique pour contrôler la puissance optique d'une diode de type VCSEL ou de toute diode pour laquelle la variation du courant de seuil en fonction de la température peut être représentée par une relation mathématique du second ordre ou plus.

La présente invention sera mieux comprise et d'autres caractéristiques apparaîtront à l'aide de la description ci-après et des figures s'y rapportant où :

- la figure 1 représentent deux courbes de puissance optique délivrée par un laser de type VCSEL en fonction du courant circulant dans le laser, relativement à deux températures de fonctionnement du laser,
- la figure 2 montre la courbe de variation du courant de seuil $I_s$ et la courbe de variation de la puissance en fonction de la température de fonctionnement pour un laser de type VCSEL,
- la figure 3 est un schéma d'un laser contrôlé selon l'invention,
- les figures 4 et 5 correspondent à des schémas plus détaillés de certains éléments de la figure 3,
- la figure 6 représente deux courbes de variation de la puissance optique d'un laser en fonction de sa température de fonctionnement,
- la figure 7 montre la courbe de variation de la tension prise aux bornes de la diode en fonction de la température,
- La figure 8 deux courbes de variation du courant de seuil mesuré et calculé, et
- la figure 9 un schéma d'un dispositif de contrôle et de commande du laser.

Sur les différentes figures les éléments correspondants sont désignés par les mêmes repères.

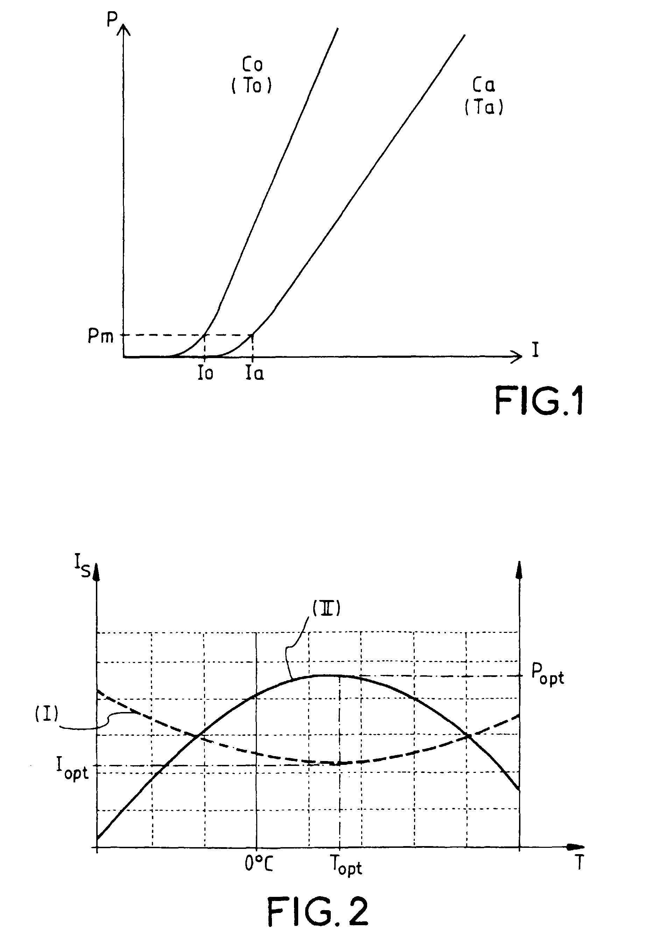

La figure 1 représente, pour deux températures différentes, les variations de la puissance optique P délivrée par une diode laser de type VCSEL en fonction du courant I qui circule dans la diode. La courbe $C_o$ correspond à la température optimale, $T_o$, de fonctionnement du laser et présente une partie sensiblement rectiligne de pente $G_o$ et la courbe $C_a$ décalée sur la droite (dans le sens des valeurs croissantes du courant) est obtenue pour une température quelconque $T_a$, et présente une partie sensiblement rectiligne de pente $G_a$ plus faible que la pente $G_o$.

La température optimale correspond au maximum de la courbe P(T) et au minimum de la courbe I(T) (figure 2).

Pour un fonctionnement correct du laser en émission, il est nécessaire de travailler dans la partie sensiblement rectiligne des courbes, juste au-dessus du courant de seuil $I_s$. De cette manière, pour une puissance optique de sortie donnée, la consommation d'énergie de l'émetteur est minimum.

Le courant de seuil $I_s$ varie de la valeur $I_o$ à la valeur la quand la température passe de $T_o$ à $T_a$. La valeur de la puissance optique $P_m$ indiquée sur la figure 1 correspond sensiblement à la puissance optique obtenue avec le courant de seuil $I_{seuil}$ quel que soit la valeur de la température.

Dans ce qui suit, il va être montré comment il est possible de modifier le courant de polarisation $I_p$ de la diode afin qu'il soit juste légèrement supérieur au courant de seuil $I_s$ quelle que soit la température de fonctionnement de la diode. Avantageusement, pour un meilleur réglage le courant de modulation $I_m$ de la diode peut être modifié afin de tenir compte de la modification de la pente $G_a$ de la partie rectiligne des courbes $C_a$.

La figure 2 montre une courbe (I) obtenue pour des diodes VCSEL Honeywell référence HFX6999, et représentant la variation du courant de seuil $I_s$ en fonction de la température T pour une puissance optique $P_m$ de 1 µW. Cette courbe est une courbe moyenne et les écarts avec cette courbe moyenne, quelle que soit la diode considérée, sont toujours très faibles. Cette courbe de variation est quasiment parabolique dans la gamme des températures considérées, dans cet exemple d'application entre -30 et +80°C. Il est donc possible de représenter le courant de seuil $I_s$ par une approximation mathématique parabolique de la forme :

$$I_s (T) = a\, T^2 + bT + c$$

et, en choisissant convenablement les coefficients a, b et c, la courbe relevée par mesures et son approximation parabolique sont quasiment confondues.

Les coefficients a, b et c sont par exemple déterminés à partir de trois points de la courbe $I_s$ (T), dans cet exemple pour les points de coordonnées :

| $I_s$ | 8,4 mA | 5,7mA | 4mA |
|---|---|---|---|
| T | -30° | 0° | 70° |

Le calcul selon une méthode connue de l'Homme du métier, conduit aux valeurs des coefficients suivantes :

a = 6,57. $10^{-7}$
b = -70,3. $10^{-6}$
c = 5,7. $10^{-3}$

L'approximation mathématique de la variation du courant de seuil en fonction de la température s'exprime alors de la manière suivantes

$$I_s (T) = 6{,}57 . 10^{-7} T^2 + (-70{,}3 . 10^{-6}) T + 5{,}7 . 10^{-3}$$

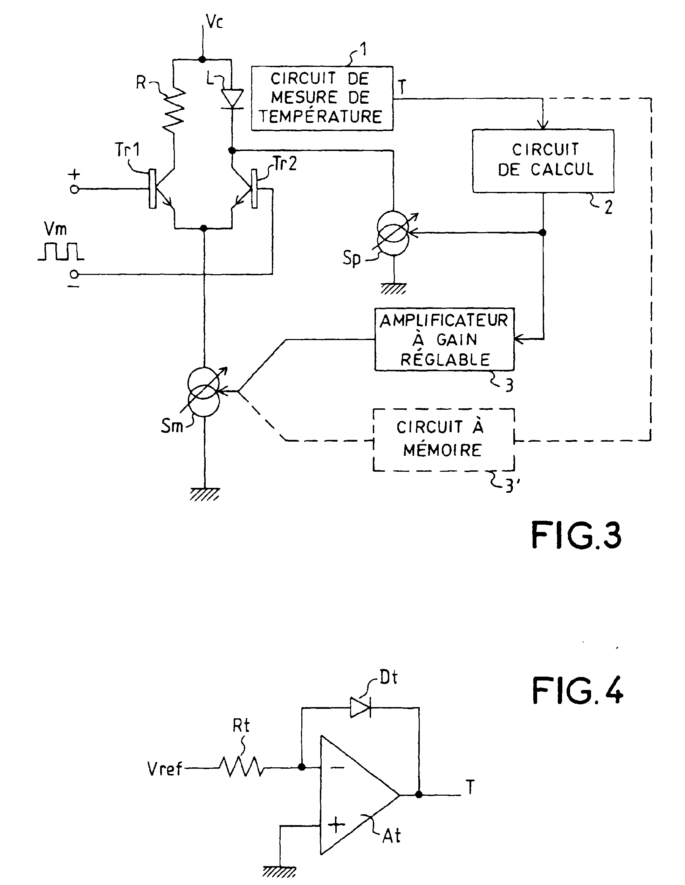

Les coefficients a, b et c sont par exemple obtenus au cours d'essais préalables, pour une diode donnée et constituent une base de donnée intégrée par exemple dans un dispositif de calcul, tel que décrit dans la figure 3.

Les coefficients peuvent aussi être déterminés en cours de fonctionnement par un dispositif numérique connu de l'Homme du métier.

La courbe (II) de la figure 2 représente la variation de la puissance optique P en fonction de la température.

La courbe (I) de la figure 2 est relative à la variation du courant de seuil en fonction de la température. De la même façon, on notera que les variations du rendement du laser (ou variation de la pente sur les courbes P=f(I) dans leur partie linéaire) en fonction de la température (figure 1) suivent une loi du second ordre similaire à celle de la figure 2 à un coefficient multiplicatif, G, près.

La figure 3 montre un premier exemple de schéma électrique d'un émetteur à diode laser L comportant un dispositif de contrôle pour régler le courant de polarisation $I_p$ et le courant de modulation $I_m$ de la diode laser en fonction de la température.

Le dispositif comporte par exemple deux transistors de type npn, $T_{r1}$, $T_{r2}$, associés en une structure différentielle avec un signal de modulation $V_m$ appliqué entre leurs bases respectives. Le collecteur de $T_{r1}$ est relié à une tension continue positive, Vc, par une résistance R. Le collecteur de Tr2 est relié d'une part à la cathode de la diode L et d'autre part à la masse par un générateur de courant, $S_p$. L'anode de la diode L est reliée à la tension Vc. Les émetteurs des transistors $T_{r1}$ et $T_{r2}$ sont reliés à la masse par un même générateur de courant $S_m$. Les générateurs $S_p$ et $S_m$ sont par exemple des générateurs variables dont le courant produit est proportionnel à l'amplitude de leur signal de commande.

Le générateur de courant $S_p$ fournit un courant de polarisation $I_p$ de la diode laser L. Ce courant est composé d'une partie fixe le à laquelle s'ajoute une partie ajustable. La partie fixe correspond par exemple au courant de seuil nominal, c'est-à-dire à un point de fonctionnement nominal en puissance de la diode que l'on s'est fixé au préalable.

Le générateur de courant $S_m$ fournit le courant de modulation $I_m$ de la diode L avec, lui aussi, une partie fixe $I_d$ et une partie ajustable.

Les moyens de contrôle en température comportent par exemple un circuit 1 de mesure de la température de la diode L, relié à un circuit de calcul 2, lui-même suivi d'un amplificateur à gain réglable 3.

Le circuit 1 de mesure de température dont un exemple de réalisation est donné sur la figure 4 fournit une tension proportionnelle à la température T qui est transmise au circuit de calcul 2. Sur les figures 3 et 4, la tension étant proportionnelle à la température T, elle est assimilée à cette dernière et notée T.

Dans la réalisation selon la figure 4, le circuit 1 comporte un amplificateur différentiel $A_t$ dont l'entrée positive ⊕ est à la masse et dont l'entrée négative - est reliée d'une part à un potentiel de référence $V_{ref}$ à travers une résistance $R_t$ et d'autre part à l'anode d'une diode $D_t$ dont la cathode est reliée à la sortie de l'amplificateur $A_t$. Les diodes $D_t$ et L font par exemple partie d'une même barrette de diodes et sont élaborées selon le même processus de fabrication, ce qui permet notamment d'optimiser la mesure de température.

Le circuit 2 calcule une tension de commande $V_s$ du générateur de courant Sp en fonction des valeurs des coefficients a, b et c précédemment obtenus par exemple, $V_s (T) = aT^2 + bT + c$.

Le générateur de courant $S_p$ fournit un courant proportionnel à $V_s$, augmenté de la partie constante le.

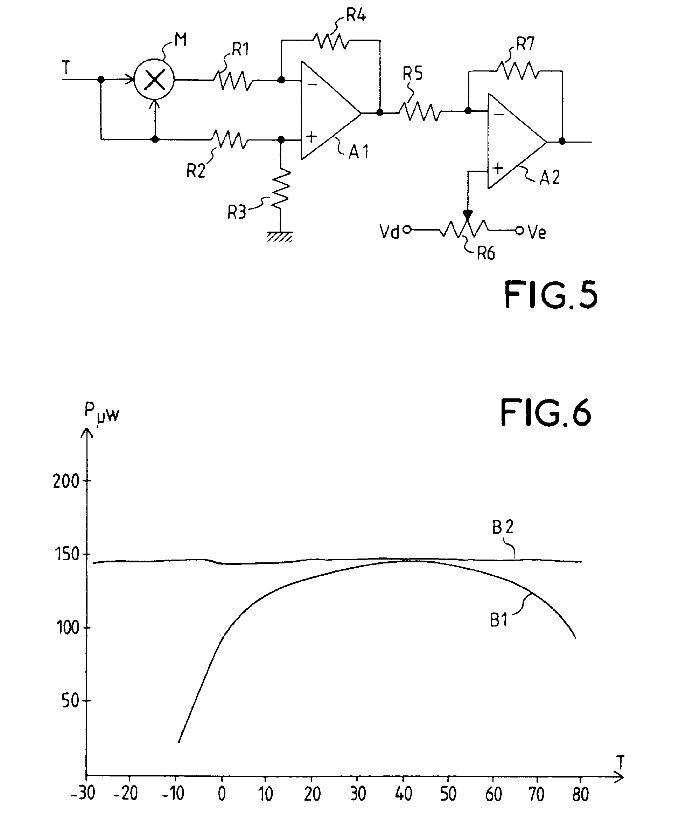

La figure 5 décrit un exemple de réalisation du circuit de calcul 2.

Le circuit comporte un multiplieur analogique, M, comportant deux entrées $E_1$ et $E_2$ relié à un premier amplificateur opérationnel $A_1$ lui-même relié à un deuxième amplificateur A2.

La température T, fournie sous forme d'une tension, est appliquée sur les deux entrées $E_1$ et $E_2$ du multiplieur M et à une première borne d'une résistance $R_2$ . La deuxième borne de $R_2$ est reliée d'une part à l'entrée positive ⊕ de l'amplificateur $A_1$ et d'autre part à la masse à travers une résistance $R_3$. La sortie S du multiplieur est reliée à l'entrée négative - de l'amplificateur $A_1$ par une résistance $R_1$, une résistance $R_4$ relie entre elles l'entrée négative - et sa sortie de l'amplificateur $A_1$.

La sortie de l'amplificateur $A_1$ est reliée par une résistance $R_5$ à l'entrée négative - de l'amplificateur $A_2$. L'entrée positive ⊕ de $A_2$ est reliée au curseur d'un potentiomètre $R_6$ dont les extrémités sont respectivement à des potentiels Vd et Ve par exemple -5 volts et +5 volts. Une résistance $R_7$ de valeur sensiblement identique que la résistance $R_5$ relie entre elles l'entrée négative - et la sortie de l'amplificateur $A_2$.

Ce circuit de calcul 2 fournit $T^2$ à la sortie du multiplieur M, $(a.T^2 + b.T)$ en sortie de l'amplificateur $A_1$, avec $a = R_4/R_1$ et $b = -(R_3+R_2)/R_4$, et $(a.T^2+b.T+c)$ à la sortie de l'amplificateur $A_2$, où c est obtenu par réglage du potentiomètre $R_6$.

Le gain de l'amplificateur à gain réglage 3 (figure 3) est réglé sur la valeur G c'est-à-dire sur le coefficient multiplicatif précédemment mentionné pour les courbes P fonction de I.

Au niveau de l'émetteur (figure 3), les courants de polarisation, $I_p$, et de modulation, $I_m$, dont la somme constitue le courant qui commande le fonctionnement de la diode laser L, sont donnés par :

$$I_p = Y.V_s + I_c$$

$$I_m = Y.Y'.G.V_s + I_d$$

où Y est la transconductance des deux générateurs, identiques dans l'exemple décrit, $S_p$, $S_m$ et où Y' est la transductance de la paire différentielle constituée par les transistors $T_{r1}$, $T_{r2}$.

Selon une variante de réalisation et afin d'effectuer un contrôle du générateur $S_m$ de courant de modulation, l'amplificateur à gain réglable 3 est remplacé par exemple par un circuit à mémoire 3' représenté en traits interrompus sur la figure 3.

Le circuit 3' reçoit le signal de mesure de température du circuit 1. Il comporte par exemple en mémoire un tableau contenant les pentes moyennes de la partie sensiblement rectiligne des courbes P = f(I) pour différentes valeurs de température. Ce circuit fournit un signal de commande au générateur $S_m$ correspondant à la différence des pentes aux températures $T_o$ et T où $T_o$ est la température optimale.

Le calcul des courants de polarisation $I_p$ et de modulation $I_m$ s'effectue de la manière mentionnée ci-dessus.

La figure 6 représente deux courbes de variation de la puissance optique P en fonction de la température de la diode laser. La courbe , l'une, $B_1$, sans contrôle en température, l'autre $B_2$, avec un contrôle en température effectué comme décrit ci-avant à l'aide en particulier des figures 3, 4 et 5. Alors que, sans le contrôle en température, la puissance disponible chute rapidement de part et d'autre d'une température qui, dans l'exemple décrit, est de l'ordre de 40°C, avec un contrôle en température elle reste quasiment stable, égale à la puissance optique maximale obtenue sans contrôle en température.

Selon un autre mode de mise en oeuvre de l'invention, le procédé comporte une étape de mesure de la tension aux bornes de la diode L.

Le principe consiste à déterminer l'évolution du courant de seuil de la diode VCSEL à partir des caractéristiques puissance/courant relévées à différentes températures (courbe II de la figure 2). La courbe $I_s$(T) est approximée par une relation du second ordre $I_s (T) = a\,T^2 + bT + c$.

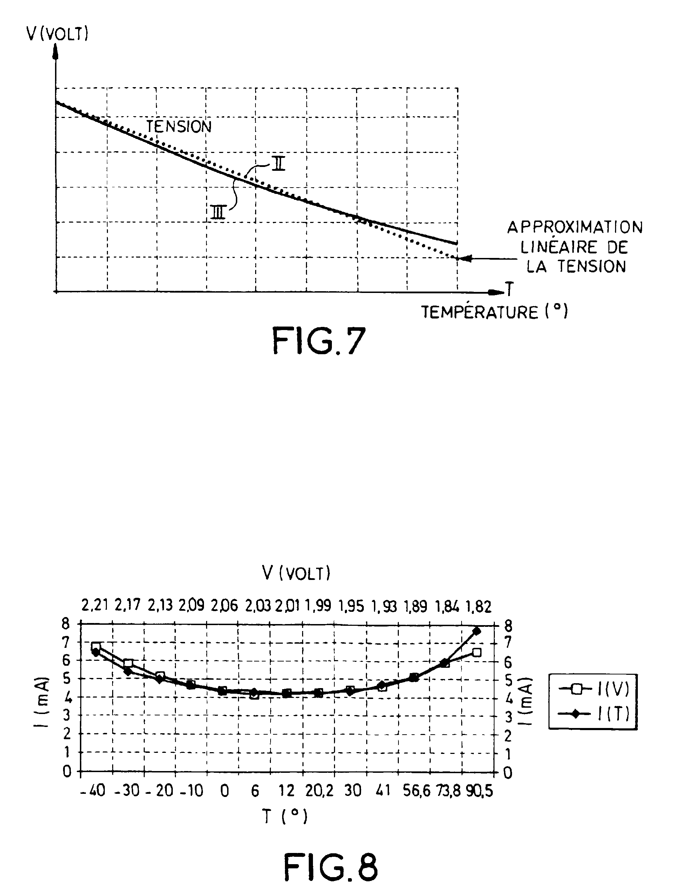

A partir des caractéristiques tension/courant à différentes températures, on détermine la courbe III (figure 7) représentant l'évolution de la tension avec la température pour une valeur de courant donnée.

Cette courbe III est assimilable à une droite D qui conserve la même pente ou sensiblement la même pente quel que soit la valeur du courant I dans une large gamme de température. L'ordonnée à l'origine de la droite varie avec le courant et peut être pris en compte dans le dispositif d'asservissement. L'équation de cette droite est de la forme $V (T) = a_1 T + b_1$ et permet d'approximer la loi de variation T(V) qui est injecté dans le polynôme du second ordre $I_s$(T) afin d'établir une relation mathématique exprimant la variation du courant de seuil avec la tension.

Dans les conditions normales de fonctionnement, à température ambiante et au courant nominal, la diode VCSEL délivre une puissance $P_{normale}$ sous une tension $V_{normale}$ qui correspondent à une valeur de courant de seuil $I_{snormale}$. La différence $(I_s - I_{s\,Normale})$ est réinjectée dans le circuit d'alimentation de la diode VCSEL de manière à recaler la diode sur le niveau de puissance $P_{Normale}$. La puissance normale et le courant de seuil normal sont deux valeurs fixées par l'utilisateur.

La figure 7 montre une courbe de variation de la tension V exprimée en Volt en fonction de la température T donnée en ° Celsius.

Le paramètre température T s'exprime de la façon suivante :

$$T = \frac{V - b_1}{a_1}$$

En remplaçant T dans $I_s (T) = aT^2 + bT + c$, on obtient :

$$V_s = AV^2 + BV + C$$

Les valeurs paramètres $a_1$ et $b_1$ sont déterminées au cours d'essais préalables pour plusieurs diodes référencées ou encore être obtenus en cours de fonctionnement. Elles sont déduites par des méthodes classiques à partir de deux points de la droite.

Les paramètres A, B et C sont déterminés à partir des coefficients a, b, c, $a_1$ et $b_1$ de la manière suivante

$$\searrow A = \frac{a}{a_1^2}$$

$$\searrow B = \frac{b}{a_1} - \frac{2 \times a \times b_1}{a_1^2}$$

$$\searrow C = \frac{b_1^2 * a}{a_1^2} - \frac{b * b_1}{a_1} + c$$

Les valeurs A, B et C, la relation $V_s = AV^2 + BV + C$, et les relations précitées

$$I_p = Y.V_s + I_c$$

$$I_m = Y.Y'.G.V_s + I_d$$

Conduisent aux valeurs de courant de polarisation $I_p$ et/ou de modulation $I_m$ à appliquer pour conserver la valeur de la puissance optique de la diode sensiblement constante.

Par exemple dans l'exemple donné à la figure 8 les courbes $I_s(T)$ et $I_s(V)$ ont été obtenues à partir des relations suivantes

$$Ith = aT^2 + bT + c = 0.000421747T^2 + 0.0104369T + 3.8494504$$

$$V = a_1T + b_1 = -0.0023T + 1.9218$$

$$V_s = AV^2 + BV + C = 79.725V^2 - 310.969V + 303.17$$

La courbe $I_s(T)$ mesurée est bien approximée par la courbe $I_s(V)$ calculée à partir de l'approximation mathématique.

A partir de la mesure de la tension V prise aux bornes de la diode il est ainsi possible de compenser la dérive en courant pour travailler à puissance constante ou sensiblement constante.

Les valeurs de courant Ip et de courant Im sont déterminées comme il a été décrit ci-dessus.

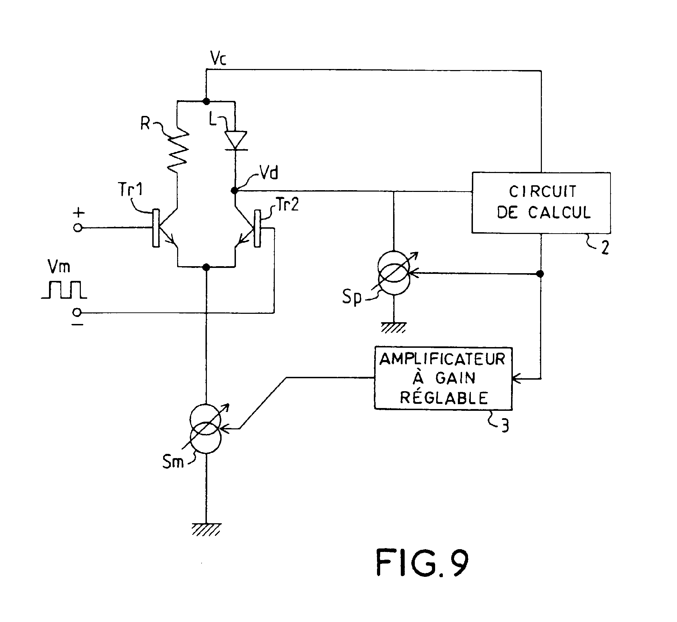

La figure 9 schématise un exemple de circuit où les éléments identiques à la figure 3 portent les mêmes références.

Le circuit de calcul 2 est adapté à calculer la valeur de la tension aux bornes de la diode VCSEL. Pour cela il est relié au point Vc qui correspond par exemple à la tension d'alimentation du circuit et à un point Vd situé à proximité de la cathode de la diode par des liaisons connues de l'Homme du métier.

Cette méthode peut sans sortir du cadre de l'invention s'appliquer pour l'asservissement du courant de modulation $I_m$.

Des résultats identiques ou sensiblement identiques sont obtenus pour tous les VCSEL d'une même barrette. A partir de la mesure de la tension, il est aussi possible de compenser la dérive en courant pour travailler à puissance sensiblement constante ou constante. La méthode de contrôle de puissance par mesure de la tension présente notamment comme avantage d'être plus simple à réaliser que la régulation de la puissance optique du VCSEL en fonction des variations de la température.

Sans sortir du cadre de l'invention il est possible de réaliser le contrôle en température de la diode uniquement à l'aide du courant de polarisation. Dans cette configuration simplifiée la translation de caractéristique en fonction de la température, comme décrite à l'aide de la figure 1, est prise en compte mais pas la variation de pente.

De même le dispositif de contrôle peut être réalisé sous forme numérique, en particulier en ce qui concerne le circuit de calcul 2 de la figure 3.

Application à la production de modules électroniques permettant de réaliser des interconnexions optoélectronique à faible coût.

**Revendications**

1. Procédé de contrôle de la puissance optique d'un émetteur laser du type comportant une diode laser et des moyens en courant pour fournir à la diode laser des courants de commande faits d'un courant de polarisation et d'un courant de modulation, caractérisé en ce qu'il comporte au moins les étapes suivantes :

   - établir une relation ou approximation mathématique du second ordre ou plus représentative des variations du courant de seuil ou de la variation de puissance de la diode laser en fonction de la température, et
   - faire varier le courant de polarisation $I_p$ et/ou la valeur du courant de modulation $I_m$ en fonction de la valeur issue de l'approximation mathématique.

2. Procédé selon la revendication 1 caractérisé en ce qu'il comporte une mesure de température pour déterminer la valeur de courant de polarisation $I_p$ et/ou le courant de modulation $I_m$.

3. Procédé selon l'une des revendications 1 et 2 caractérisé en ce qu'il comporte une étape de mesure de la tension V aux bornes de la diode laser et une étape où l'on établit une relation entre la variation de la tension V et la température T pour déterminer la valeur du courant de polarisation $I_p$ et/ou le courant de modulation $I_m$.

4. Procédé selon la revendication 1, caractérisé en ce que, ayant en mémoire, pour la diode, des valeurs de pentes de la partie sensiblement rectiligne des courbes P = f(I), en fonction de la température de fonctionnement, où P est la puissance optique délivrée par la diode en fonction du courant I qui traverse la diode, il consiste à faire varier linéairement le courant de modulation en fonction de la différence des pentes aux températures T et To, où T est la température de fonctionnement de la diode et To la température de fonctionnement optimum de la diode.

5. Dispositif de contrôle en température d'une diode laser du type comportant une diode laser, un générateur de courant de polarisation ($S_p$) et/ou un générateur de courant de modulation ($S_m$), caractérisé en ce qu'il comporte au moins :

   - un dispositif (2) adapté à établir et/ou de mémoriser au moins une relation mathématique de second ordre ou plus entre la variation du courant de seuil $I_s$ de la diode laser et la température T et de déterminer une valeur de courant,
   - un dispositif (1) capable de déterminer au moins un paramètre représentatif de la variation du courant de seuil ou de la puissance optique de la diode en fonction de la température de la diode,
   - un dispositif de commande et de contrôle (2) adapté à générer un signal de commande pour faire varier le courant de polarisation $I_p$ et/ou le courant de modulation $I_m$ en fonction du résultat issu de ladite relation mathématique.

6. Dispositif selon la revendication 5 caractérisé en ce qu'il comporte un dispositif (1) de mesure de la température.

7. Dispositif selon la revendication 5 caractérisé en ce qu'il comporte un dispositif de mesure de la tension aux bornes de la diode et un dispositif adapté à établir et/ou à mémoriser une relation entre la variation de la tension en fonction de la température et à fournir une valeur de température en fonction de la tension.

8. Dispositif de contrôle selon la revendication 5, caractérisé en ce que les moyens de contrôle (2, 3) fournissent au générateur de courant de modulation ($S_m$) un signal de commande tel que la diode laser travaille à pente constante quelle que soit la température pour les courbes donnant P en fonction de I.

9. Dispositif de contrôle selon la revendication 5, caractérisé en ce que les moyens de contrôle (2, 3') fournissent au générateur de courant de modulation ($S_m$) un signal de commande proportionnel à la différence des pentes, dans leur partie rectiligne, des courbes donnant P en fonction de I pour la température de fonctionnement de la diode laser et pour la température optimale de fonctionnement de la diode laser.

**10.** Application du dispositif selon l'une des revendications 5 à 9 ou du procédé selon l'une des revendications 1 à 4 au contrôle d'une diode de type VECSEL.

FIG.1

FIG.2

Vc

R

L

CIRCUIT DE
MESURE DE
TEMPÉRATURE

1

T

Tr1

Tr2

CIRCUIT
DE CALCUL

2

+

Vm

Sp

AMPLIFICATEUR
À GAIN
RÉGLABLE

3

Sm

CIRCUIT À
MÉMOIRE

3'

# FIG.3

# FIG.4

Dt

Rt

Vref

−

+

At

T

FIG.5

FIG.6

V (VOLT)

TENSION

Ⅱ

Ⅲ

APPROXIMATION
LINÉAIRE DE
LA TENSION

T

TEMPÉRATURE (°)

# FIG.7

V (VOLT)

| 2,21 | 2,17 | 2,13 | 2,09 | 2,06 | 2,03 | 2,01 | 1,99 | 1,95 | 1,93 | 1,89 | 1,84 | 1,82 |

I (mA)

I (mA)

□ I(V)
◆ I(T)

-40  -30  -20  -10   0   6   12  20,2  30   41  56,6 73,8 90,5

T (°)

# FIG.8

FIG.9

Office européen
des brevets

**RAPPORT DE RECHERCHE EUROPEENNE**

Numéro de la demande

EP 00 40 2512

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | PATENT ABSTRACTS OF JAPAN<br>vol. 015, no. 165 (E-1061),<br>25 avril 1991 (1991-04-25)<br>-& JP 03 036777 A (FUJITSU LTD),<br>18 février 1991 (1991-02-18)<br>* abrégé; figures 5-7 * | 1,2,4-6,<br>8-10 | H01S5/068 |
| X | US 4 700 057 A (SAKAI MITSUGU)<br>13 octobre 1987 (1987-10-13) | 1,2,5,6,<br>10 | |
| Y | * colonne 3, ligne 32-51; figure 1 * | 1,2,4-6,<br>8-10 | |
| Y | US 5 018 154 A (OHASHI TSUYOSHI)<br>21 mai 1991 (1991-05-21)<br>* le document en entier * | 1,2,4-6,<br>8-10 | |
| X | EP 0 793 316 A (LUCENT TECHNOLOGIES INC)<br>3 septembre 1997 (1997-09-03)<br>* colonne 4, ligne 39-55 * | 1,2,4-6,<br>8-10 | |
| A | EP 0 421 674 A (AMERICAN TELEPHONE & TELEGRAPH) 10 avril 1991 (1991-04-10)<br>* le document en entier * | 1,2,4-6,<br>8-10 | DOMAINES TECHNIQUES RECHERCHES (Int.Cl.7)<br><br>H01S |
| A | PATENT ABSTRACTS OF JAPAN<br>vol. 014, no. 089 (E-0891),<br>19 février 1990 (1990-02-19)<br>& JP 01 298780 A (HITACHI ELECTRON ENG CO LTD), 1 décembre 1989 (1989-12-01)<br>* abrégé * | 1,3,7 | |

-/--

Le présent rapport a été établi pour toutes les revendications

| Lieu de la recherche | Date d'achèvement de la recherche | Examinateur |
|---|---|---|
| LA HAYE | 8 janvier 2001 | Claessen, L |

EP 1 085 624 A1

**Office européen des brevets**

# RAPPORT DE RECHERCHE EUROPEENNE

Numéro de la demande

EP 00 40 2512

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | LUDVIGSEN H ET AL: "Frequency stabilization of a GaAlAs semiconductor laser by voltage control" APPLIED OPTICS, 20 JUNE 1992, USA, vol. 31, no. 18, pages 3384-3386, XP002155240 ISSN: 0003-6935 * page 3384, colonne de droite, alinéa 2 * | 1,3,7 | |
| A | ALBANESE A: "An automatic bias control (ABC) circuit for injection lasers" BELL SYSTEM TECHNICAL JOURNAL, MAY-JUNE 1978, USA, vol. 57, no. 5, pages 1533-1544, XP002155241 ISSN: 0005-8580 * le document en entier * | 1,3,7 | |

DOMAINES TECHNIQUES RECHERCHES (Int.Cl.7)

Le présent rapport a été établi pour toutes les revendications

| Lieu de la recherche | Date d'achèvement de la recherche | Examinateur |
|---|---|---|
| LA HAYE | 8 janvier 2001 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

**ANNEXE AU RAPPORT DE RECHERCHE EUROPEENNE
RELATIF A LA DEMANDE DE BREVET EUROPEEN NO.**

EP 00 40 2512

La présente annexe indique les membres de la famille de brevets relatifs aux documents brevets cités dans le rapport de recherche européenne visé ci–dessus.
Lesdits members sont contenus au fichier informatique de l'Office européen des brevets à la date du
Les renseignements fournis sont donnés à titre indicatif et n'engagent pas la responsabilité de l'Office européen des brevets.

08–01–2001

| Document brevet cité au rapport de recherche | | Date de publication | Membre(s) de la famille de brevet(s) | | Date de publication |
|---|---|---|---|---|---|
| JP 03036777 | A | 18–02–1991 | JP | 2744650 B | 28–04–1998 |
| US 4700057 | A | 13–10–1987 | JP | 61090540 A | 08–05–1986 |
| US 5018154 | A | 21–05–1991 | JP | 3099485 A | 24–04–1991 |
| | | | JP | 3123091 A | 24–05–1991 |
| EP 0793316 | A | 03–09–1997 | JP | 9321375 A | 12–12–1997 |
| | | | US | 5844928 A | 01–12–1998 |
| EP 0421674 | A | 10–04–1991 | US | 5043992 A | 27–08–1991 |
| | | | DE | 69007408 D | 21–04–1994 |
| | | | DE | 69007408 T | 25–08–1994 |
| | | | HK | 104494 A | 07–10–1994 |
| | | | JP | 1961779 C | 25–08–1995 |
| | | | JP | 3133187 A | 06–06–1991 |
| | | | JP | 6080853 B | 12–10–1994 |
| | | | SG | 117194 G | 25–11–1994 |
| JP 01298780 | A | 01–12–1989 | AUCUN | | |

EPO FORM P0460

Pour tout renseignement concernant cette annexe : voir Journal Officiel de l'Office européen des brevets, No.12/82